# FASCICULE DE BREVET EUROPEEN

(11) **EP 1 369 909 B1**
(45) Date de publication et mention de la délivrance du brevet: **02.02.2011**
(21) Numéro de dépôt: 03291262.8
(22) Date de dépôt: 27.05.2003
(51) Int. Cl.: H01L 21/336, H01L 21/265

(54) **Procédé de fabrication d'un transistor MOS de longueur de grille réduite, et circuit intégré comportant un tel transistor**
Herstellungsverfahren für MOS-Transistor mit verringerter Gate-Länge und einen solchen Transistor enthaltener integrierter Schaltkreis
Method of fabricating a MOS transistor with reduced gate length and integrated circuit comprising such transistor

(30) Priorité: 04.06.2002 FR 0206870
(43) Date de publication de la demande: 10.12.2003
(73) Titulaire: STMicroelectronics S.A., 92120 Montrouge (FR); Commissariat à l'Énergie Atomique et aux Énergies Alternatives, 75015 Paris (FR)
(72) Inventeur: Lenoble, Damien, 38610 Gieres (FR); Guilmeau, Isabelle, 38100 Grenoble (FR)
(74) Mandataire: Casalonga, Axel

(56) Documents cités:
- GB-A- 2 362 029
- US-A- 5 492 847
- US-A- 5 736 446
- US-B1- 6 274 445

## Description

L'invention concerne les circuits intégrés, et notamment mais non exclusivement les transistors à effet de champ à grilles isolées (transistors MOSFET) de longueur de grille réduite, par exemple inférieure à 180 nanomètres, et en particulier ceux de dimensions nanométriques, c'est-à-dire dont la longueur de grille est inférieure à 100 nm environ.

La fabrication des transistors MOS de dimensions réduites, en particulier nanométriques, et d'architecture classique, se heurte aujourd'hui à des problèmes intrinsèques limitant leurs caractéristiques de fonctionnement.

Parmi ces problèmes, les effets dits « canaux courts » (abaissement de la tension de seuil du transistor lorsque la longueur de grille diminue et par conséquent la longueur de canal diminue) deviennent prépondérants, ce qui a alors un impact négatif sur les caractéristiques en courant des transistors.

Il est reconnu que ces effets « canaux courts » sont liés à une diminution de la longueur effective du canal de conduction à cause de la diffusion latérale (c'est-à-dire sous l'électrode de grille) des zones d'extension de source et de drain (communément désignée par l'homme du métier sous le vocable de « zone LDD »).

Un des moyens efficaces pour réduire ces effets « canaux courts » parasites est de réduire la profondeur des jonctions de ces zones d'extension, réduisant de ce fait la diffusion latérale (qui est proportionnelle à la profondeur verticale de la jonction) de ces zones d'extension.

Toutefois, la réduction de la profondeur des jonctions de ces zones s'accompagne d'une augmentation de la résistance de couche de ces jonctions lorsque les profondeurs deviennent inférieures à 40 nm dans le cas des procédés usuels de fabrication qui prévoient une implantation ionique des espèces dopantes (typiquement bore et arsenic), puis une activation thermique par un recuit à haute température.

Il convient également de noter que des profondeurs inférieures à 30 nm sont recommandées pour des technologies CMOS inférieures à 100 nm.

Et, l'augmentation de la résistance de couche de la jonction augmente la valeur de la résistance parasite du dispositif, limitant ainsi les performances en courant de saturation des transistors.

Ainsi, les technologues sont aujourd'hui confrontés au compromis entre le contrôle des effets canaux courts (c'est-à-dire le contrôle de la tension de seuil pour maintenir le courant de fuite du transistor en deçà des valeurs désirées) et l'augmentation des performances des transistors (courant de saturation à l'état passant) partiellement liées à la valeur de la résistance série parasite (donc à la résistance de jonction).

Une solution proposée consiste à mettre en place sur les flancs de la grille du transistor des régions latérales isolantes (espaceurs) dites de décalage (espaceurs offset) permettant de décaler le positionnement latéral des jonctions LDD lors de l'implantation de celles-ci. L'utilisation de jonctions profondes (supérieures à 40 nm) faiblement résistives, est alors possible.

Une telle solution permet de contrôler la longueur effective de conduction du canal, via la largeur des espaceurs offset, garantissant ainsi un bon contrôle des effets canaux courts tout en intégrant des jonctions peu résistives pour des performances en courant accrues.

Toutefois, l'intégration d'une telle solution se heurte à des difficultés de réalisations technologiques et à l'ajout d'étapes de fabrication coûteuses.

On peut notamment citer comme difficultés technologiques, la réalisation d'un dépôt conforme d'un matériau à base de silicium, la gravure anisotrope et sélective de ce dépôt avec arrêt sur la zone active, quelle que soit la densité surfacique des transistors, ainsi que la réalisation des espaceurs standards qui doivent être réajustés.

En effet, les espaceurs offset sont fabriqués habituellement avec des matériaux à base de silicium et il est par conséquent nécessaire de faire une gravure anisotrope des dépôts conformes afin de réduire l'épaisseur des dépôts au pied des espaceurs. Car sans cette réduction d'épaisseur, l'augmentation d'énergie nécessaire à la traversée de cet empilement pour arriver dans la zone active du transistor (c'est-à-dire pour réaliser les zones LDD) est telle que l'augmentation de la dispersion latérale des dopants compense le décalage apporté par les espaceurs offset.

Et, dans certains cas, la dispersion latérale sous l'électrode de grille est même dégradée.

Le document US 5 736 446 concerne une méthode de fabrication d'un transistor MOS comportant des espaceurs ayant un vide d'air. Un espaceur de nitrure pour délimiter l'espace du vide d'air est formé sur le substrat, à côté de la structure de grille. Un espaceur de silicium amorphe pour fermer le vide d'air est formé à côté de l'espaceur de nitrure. La partie supérieure de l'espaceur de silicium amorphe est fortement dopé au cours de l'implantation de la source / du drain. Après avoir enlevé l'espaceur de nitrure, l'espaceur amorphe de silicium dopé est oxydé par un procédé d'oxydation par voie humide pour former un espaceur d'oxyde dopé. Les dopants implantes dans l'espaceur de silicium amorphe migrent dans le substrat et des régions d'extensions dopées sont formées.

L'invention vise à apporter une solution à ces problèmes.

Un but de l'invention est de permettre d'obtenir un décalage latéral des jonctions des zones LDD d'une façon très simple, sans modification significative d'un procédé de fabrication standard.

L'invention propose donc un procédé de fabrication d'un transistor MOS comprenant une étape de réalisation de régions d'extension de source et de drain (régions LDD), comportant la formation d'une région de grille sur un substrat semiconducteur et une implantation de dopants dans le substrat, de part et d'autre et à distance de la grille du transistor.

Selon une caractéristique générale de l'invention, ladite étape de réalisation des régions d'extension de source et de drain comporte la formation d'une couche intermédiaire sur les flancs de la grille et sur la surface du substrat, cette couche intermédiaire étant formée d'un matériau moins dense que le dioxyde de silicium. Ladite implantation de dopants est alors effectuée à travers la partie de couche intermédiaire située sur la surface du substrat.

Ainsi, la partie de la couche intermédiaire située sur les flancs verticaux de la grille permet de décaler latéralement l'implantation. Par ailleurs, du fait de la faible densité du matériau de la couche intermédiaire, l'augmentation de l'énergie d'implantation nécessaire à la traversée de cette couche reste faible. Ainsi, il subsiste un gain significatif sur la dispersion latérale des jonctions LDD sous la grille par rapport au ca classique.

L'invention permet donc d'intégrer facilement (sans gravure supplémentaire par rapport au procédé classique) des jonctions profondes tout en préservant la longueur électrique du canal de conduction.

Le matériau formant la couche intermédiaire peut être avantageusement un matériau anti-réflecteur utilisé comme sous-couche anti-réflectrice lors d'une insolation d'une résine photosensible. Un tel matériau est par exemple connu par l'homme du métier sous la dénomination de « matériau BARC » (bottom anti-reflective coater) disponible par exemple auprès de la Société SHIPLEY. Ce matériau est un matériau inorganique utilisé en photolithographie afin d'éviter les réflexions parasites du substrat lors de l'insolation de la résine.

L'invention est donc remarquable en ce sens qu'elle utilise un matériau dont le but et la fonction étaient jusqu'à présent totalement différents de ceux visés ici. Ainsi, alors que dans le procédé classique de photolithographie, la couche anti-réflective est traditionnellement gravée après le développement des motifs de résine, cette couche de matériau de type BARC, déposée de manière conforme et ayant une épaisseur variant entre 1 et 100 nm, est, selon l'invention, volontairement préservée après le développement des motifs de résine.

En variante, il serait également possible d'utiliser, comme matériau de couche intermédiaire, du dioxyde de silicium poreux.

Selon un mode de mise en oeuvre de l'invention, le matériau formant la couche intermédiaire (CI) peut être gravé sélectivement par rapport au silicium et on peut retirer la couche intermédiaire après ladite implantation de dopants. C'est le cas notamment lorsque la couche utilisée est du type BARC.

Ceci étant, en variante, en particulier lorsque le matériau utilisé pour la couche intermédiaire est du silicium poreux, on peut laisser subsister sur les flancs de la grille et sur une partie du substrat, une portion de la couche intermédiaire après ladite implantation. On réalise alors des régions latérales isolantes (espaceurs) s'appuyant sur les flancs de la grille et sur une partie du substrat, ces régions latérales isolantes comportant ladite portion résiduelle de couche intermédiaire surmontée d'un autre matériau, par exemple du nitrure de silicium. Les espaceurs finalement réalisés sont alors bi-couches.

On choisit avantageusement l'énergie d'implantation de façon à obtenir un maximum de distribution de dopants à une profondeur d'au moins 3 à 4 nm.

Le fait de s'autoriser, dans le cadre de cette invention, des énergies d'implantation plus élevées, permet de limiter l'impact de la ré-oxydation parasite liée à l'opération de gravure de la couche intermédiaire formée de matériau BARC, puisque la distribution des dopants est située plus loin de la surface ré-oxydée. La consommation de dopants dans l'oxyde reste alors marginale.

Il convient de noter qu'il est également possible de faire diffuser les dopants, via un recuit thermique d'activation, avant le retrait de la couche intermédiaire, afin de se prémunir de tout effet parasite de surface lié à la gravure ou à tout nettoyage postérieur.

L'invention a également pour objet un circuit intégré comportant au moins un transistor obtenu par le procédé, tel que défini ci-avant.

Selon un mode de réalisation, le transistor comporte des régions latérales isolantes s'appuyant sur les flancs de la grille et sur une partie du substrat, ces régions latérales isolantes comportant une couche intermédiaire formée d'un matériau moins dense que le silicium, par exemple du silicium poreux, cette couche intermédiaire étant surmontée d'un autre matériau.

D'autres avantages et caractéristiques de l'invention apparaîtront à l'examen de la description détaillée de modes de réalisation et de mise en oeuvre, nullement limitatifs, et des dessins annexés, sur lesquels :
- les figures 1 à 3 illustrent un premier mode de mise en oeuvre d'un procédé selon l'invention, aboutissant à un premier mode de réalisation d'un transistor selon l'invention ; et
- la figure 4 illustre une variante de l'invention.

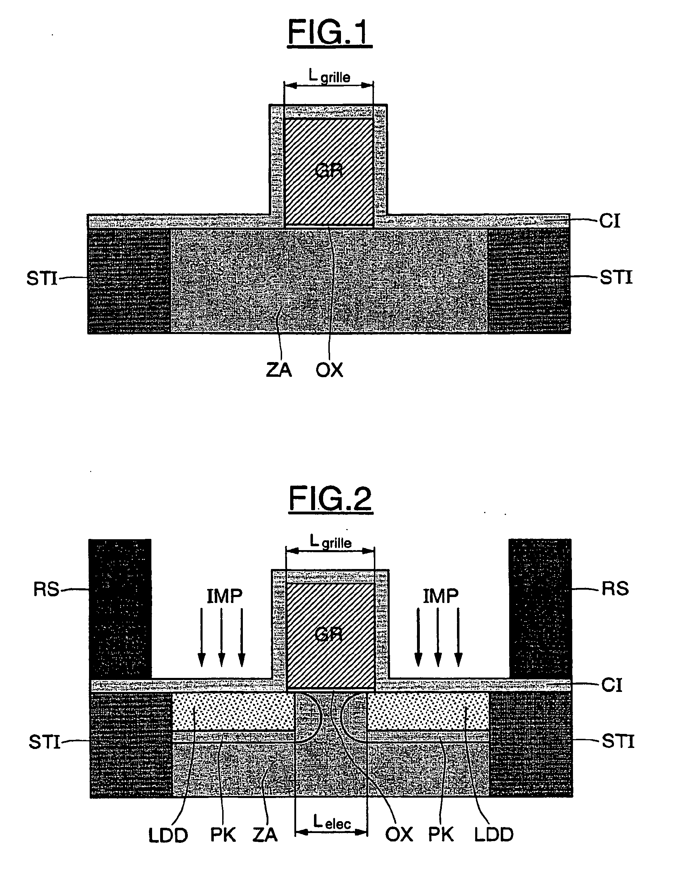

Sur les figures 1 à 3, la référence ZA désigne une zone active d'un substrat semiconducteur en silicium, délimitée latéralement par des zones d'isolement latérales STI, par exemple du type tranchées peu profondes.

Ces régions d'isolement latérales STI sont réalisées de façon classique et connue en soi par l'homme du métier.

Après avoir également réalisé de façon classique et connue en soi la grille GR du transistor, isolée de la zone active par un oxyde de grille OX, on dépose une couche intermédiaire CI formée ici d'un matériau de type BARC, en une épaisseur typiquement comprise entre 1 et 100 nm.

Cette couche CI est déposée de manière conforme. Ce matériau inorganique de type BARC présente une très faible densité, typiquement 1 g/cm³.

Puis, on effectue (figure 2), de façon classique et connue en soi, un dépôt d'une couche de résine RS que l'on développe et que l'on grave localement, de façon à découvrir la couche intermédiaire CI.

Puis, on procède à l'implantation de dopants IMP dans l'orifice délimité par le bloc de résine. Cette implantation IMP se fait ainsi notamment à travers la portion horizontale de la couche CI, de façon à former les régions LDD.

Le décalage latéral, apporté par la partie verticale de la couche CI, est ici supérieur à l'augmentation de la dispersion latérale liée à l'augmentation de l'énergie d'implantation nécessaire à la traversée en profondeur de la couche CI. On obtient donc une longueur électrique L_{elec}, certes inférieure à la longueur de la grille L_{grille}, mais supérieure à celle que l'on aurait obtenue dans le procédé classique de l'art antérieur.

En ce qui concerne l'énergie d'implantation, qui doit être un peu plus élevée que celle utilisée dans le procédé de l'art antérieur, en raison de la traversée de la couche CI, l'homme du métier saura la choisir, de façon à obtenir un maximum de distribution des dopants à une profondeur d'au moins 3 à 4 nm, par exemple 10 nm.

A titre indicatif, pour un maximum de distribution à 10 nm avec une implantation à travers 20 nm de couche CI formée de matériau de type BARC, on obtient une dispersion latérale post-implantation sous la grille diminuée d'environ 10 nm par rapport à une implantation à travers une épaisseur équivalente de dioxyde de silicium (densité 2,3 g/cm³) et diminuée d'environ 7 nm par rapport à une implantation classique directe dans du silicium c'est à dire sans espaceurs de décalage.

On procède également, bien que cela ne soit pas absolument indispensable, à la formation, par implantation oblique de dopants de type opposé à celui utilisé pour les implantations de source, drain et LDD, à des régions PK (« pocket » en langue anglaise). L'implantation de ces régions PK peut s'effectuer avant ou après l'implantation des zones LDD. Ces régions PK contribuent à améliorer le contrôle des effets canaux courts et évitent notamment une trop grande chute de la tension de seuil du transistor.

Contrairement à la mise en oeuvre d'espaceurs « offset » selon l'art antérieur, il est possible dans le cadre de la présente invention de réaliser l'implantation des zones PK avec le même niveau de masquage photo-lithographique que celui des zones LDD en préservant leur efficacité. En effet il est connu que l'efficacité de ces poches est reliée à leur localisation précise dans la zone active sous la grille. Cette localisation est d'autant moins dispersée que leur énergie d'implantation est faible. Dans le cas d'espaceurs offset selon l'art antérieur, il est nécessaire d'augmenter significativement l'énergie d'implantation des zones PK. Aussi selon l'art antérieur, il est alors usuel de faire un premier niveau de masquage (avant les espaceurs offset) pour implanter ces zones PK de façon auto-alignée sur la grille, de retirer la résine, de former les espaceurs offset et de refaire un nouveau niveau de masquage pour les zones LDD.

Dans le cadre de la présente invention, il est possible de s'affranchir de cette coûteuse limitation puisque la densité des matériaux utilisés est faible, et que par conséquent l'augmentation d'énergie pour implanter les poches PK à travers la couche intermédiaire est tout à fait acceptable.

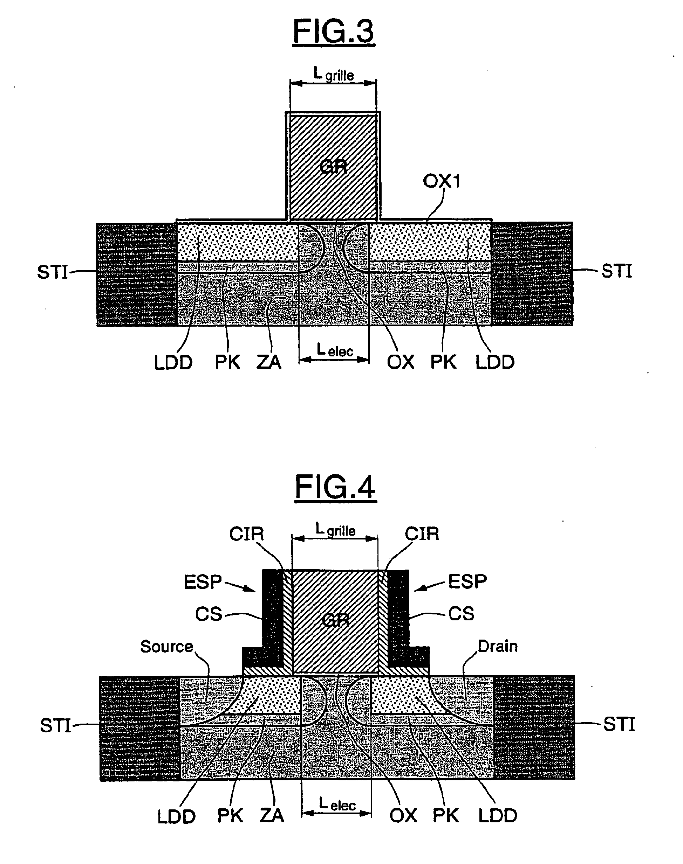

L'étape suivante consiste à retirer par gravure sous plasma contenant de l'oxygène, la couche CI (figure 3) ainsi que la résine RS.

Le type de gravure permettant le retrait de la couche CI est oxydant et conduit à la formation d'un oxyde de surface OX1.

Le fait de s'autoriser, dans le cadre de cette invention, une énergie d'implantation plus élevée, permet de limiter l'impact de la ré-oxydation parasite OX1 liée à la gravure du matériau BARC, puisque la distribution de dopants est située plus loin de la surface ré-oxydée. La consommation de dopants dans l'oxyde reste alors marginale.

Par ailleurs, selon une variante de l'invention, on peut procéder à l'implantation des zones PK après retrait de la couche CI et avant retrait de la résine. Une telle variante permet d'implanter les zones PK de façon auto-alignée sur la grille tout en décalant l'implantation des zones LDD pour contrôler les effets canaux courts et cela avec le même niveau photolithographique.

Le reste du procédé de fabrication du transistor est classique et connu en soi et comporte notamment le retrait de la couche OX1, puis la formation d'espaceurs isolants, par exemple en nitrure de silicium, sur les flancs de la grille.

L'invention n'est pas limitée aux modes de réalisation et de mise en oeuvre qui viennent d'être décrits, mais en embrasse toutes les variantes.

Ainsi, le matériau de type BARC peut être remplacé par tout matériau de faible densité (inférieur au dioxyde de silicium) et capable d'être gravé sélectivement par rapport au silicium.

A titre d'exemple, on peut citer du dioxyde de silicium poreux. Un tel matériau présente également l'avantage de ne pas modifier significativement le procédé de fabrication classique d'un transistor MOS.

En effet, comme illustré sur la figure 4, on peut, après l'implantation des zones LDD, ne retirer qu'une partie de la couche intermédiaire CI et laisser subsister sur les flancs latéraux de la grille et sur la surface du substrat, une portion résiduelle CIR de couche intermédiaire. Puis, on forme, de façon classique et connue en soi, une couche supérieure CS, par exemple en nitrure de silicium, sur cette couche CIR, de façon à former des espaceurs ESP bi-couches.

## Revendications

1. Procédé de fabrication d'un transistor MOS, comprenant une étape de réalisation de régions d'extension de source et de drain comportant la formation d'une région de grille sur un substrat semiconducteur et une implantation de dopants dans le substrat de part et d'autre et à distance de la grille du transistor, ladite étape de réalisation des régions d'extension de source et de drain comporte la formation d'une couche intermédiaire (CI) sur les flancs de la grille (GR) et sur la surface du substrat, ladite implantation de dopants (IMP) est effectuée à travers la partie de ladite couche intermédiaire située sur le substrat, **caractérisé par le fait que** cette couche intermédiaire est formée d'un matériau moins dense que le dioxyde de silicium.

2. Procédé selon la revendication 1, **caractérisé par le fait que** le matériau formant la couche intermédiaire (CI) est un matériau anti-réflecteur utilisé comme sous-couche anti-réflectrice lors d'une insolation d'une résine photosensible.

3. Procédé selon la revendication 1, **caractérisé par le fait que** le matériau formant la couche intermédiaire (CI) est du dioxyde de silicium poreux.

4. Procédé selon l'une des revendications précédentes, **caractérisé par le fait qu'**on forme des régions (PK) par implantation oblique de dopants de type opposé à celui utilisé pour les implantations de source, drain et des régions d'extension de source et de drain (LDD), et **par le fait qu'**on effectue cette implantation oblique à travers la couche intermédiaire.

5. Procédé selon l'une des revendications précédentes, **caractérisé par le fait que** le matériau formant la couche intermédiaire (CI) peut être gravé sélectivement par rapport au silicium, et **par le fait qu'**on retire ladite couche intermédiaire après ladite implantation de dopants.

6. Procédé selon la revendication 5, **caractérisé par le fait qu'**on forme des régions (PK) par implantation oblique de dopants de type opposé à celui utilisé pour les implantations de source, drain et des régions d'extension de source et de drain (LDD), et **par le fait qu'**on effectue cette implantation oblique après retrait de la couche intermédiaire.

7. Procédé selon la revendication 3, **caractérisé par le fait qu'**on laisse subsister sur les flancs de la grille (GR) et sur une partie du substrat, une portion (CIR) de la couche intermédiaire après ladite implantation, et **par le fait qu'**on réalise des régions latérales isolantes s'appuyant sur les flancs de la grille et sur une partie du substrat, ces régions latérales isolantes (ESP) comportant ladite portion résiduelle de couche intermédiaire surmontée d'un autre matériau.

8. Procédé selon l'une des revendications précédentes, **caractérisé par le fait qu'**on choisit l'énergie d'implantation de façon à obtenir un maximum de distribution de dopants à une profondeur d'au moins 3 à 4 nanomètres.

9. Procédé selon l'une des revendications précédentes, **caractérisé par le fait que** la dimension de la grille comptée parallèlement à la longueur du canal est inférieure à 180 nanomètres, par exemple inférieure à 100 nanomètres.

## Claims

1. Process for fabricating a MOS transistor, comprising a step of producing source and drain extension regions, consisting in forming a gate region on a semiconductor substrate and in implanting dopants into the substrate on either side of and at a certain distance from the gate of the transistor, said step of producing the source and drain extension regions consists in forming an intermediate layer (CI) on the sidewalls of the gate (GR) and on the surface of the substrate and said implantation of dopants (IMP) is carried out through that part of said intermediate layer which is located on the substrate, **characterized in that** this intermediate layer is formed from a material that is less dense than silicon dioxide.

2. Process according to Claim 1, **characterized in that** the material forming the intermediate layer (CI) is an antireflective material used as antireflective sublayer during exposure of a photoresist.

3. Process according to Claim 1, **characterized in that** the material forming the intermediate layer (CI) is porous silicon dioxide.

4. Process according to one of the preceding claims, **characterized in that** pockets (PK) are formed by oblique implantation of dopants of the opposite type to that used for the source, drain and source and drain extension region (LDD) implantations and **in that** this oblique implantation is carried out through the intermediate layer.

5. Process according to one of the preceding claims, **characterized in that** the material forming the intermediate layer (CI) may be etched selectively with respect to silicon and **in that** said intermediate layer is removed after said implantation of dopants.

6. Process according to Claim 5, **characterized in that** pockets (PK) are formed by oblique implantation of dopants of the opposite type to that used for the source, drain and source and drain extension region (LDD) implantations and **in that** this oblique implantation is carried out after the intermediate layer has been removed.

7. Process according to Claim 3, **characterized in that**, after said implantation, a portion (CIR) of the intermediate layer is left to remain on the sidewalls of the gate (GR) and on part of the substrate and **in that** insulating lateral regions resting on the sidewalls of the gate and on part of the substrate are produced, these insulating lateral regions (ESP) comprising said residual portion of the intermediate layer surmounted by another material.

8. Process according to one of the preceding claims, **characterized in that** the implantation energy is chosen so as to obtain a maximum dopant distribution at a depth of at least 3 to 4 nanometres.

9. Process according to one of the preceding claims, **characterized in that** the length of the gate measured parallel to the length of the channel is less than 180 nanometres, for example less than 100 nanometres.

## Patentansprüche

1. Verfahren zum Herstellen eines MOS-Transistors, das einen Schritt des Verwirklichens von Source- und Drain-Erweiterungsbereichen enthält und das Bilden eines Gate-Bereichs auf einem Halbleitersubstrat und einer Implantation von Störstellen in dem Substrat beiderseits des Gates des Transistors und in einem Abstand hiervon enthält, wobei der Schritt des Verwirklichens von Source- und Drain-Erweiterungsbereichen das Bilden einer Zwischenschicht (CI) an den Seitenflächen des Gates (GR) und auf der Oberfläche des Substrats enthält, wobei die Implantation von Störstellen (IMP) durch den Teil der Zwischenschicht, der sich auf dem Substrat befindet, erfolgt, **dadurch gekennzeichnet, dass** diese Zwischenschicht aus einem Material gebildet ist, das weniger dicht ist als Siliciumdioxid.

2. Verfahren nach Anspruch 1, **dadurch gekennzeichnet, dass** das die Zwischenschicht (CI) bildende Material ein Antireflexionsmaterial ist, das als eine nicht reflektierende Unterschicht bei einer Belichtung eines lichtempfindlichen Harzes verwendet wird.

3. Verfahren nach Anspruch 1, **dadurch gekennzeichnet, dass** das die Zwischenschicht (CI) bildende Material poröses Siliciumdioxid ist.

4. Verfahren nach einem der vorhergehenden Ansprüche, **dadurch gekennzeichnet, dass** Bereiche (PK) durch schräge Implantation von Störstellen des Typs, der zu jenem entgegengesetzt ist, der für die Implantationen der Source, des Drains und der Source- und Drain-Erweiterungsbereiche (LDD) verwendet wird, gebildet werden und dass diese schräge Implantation durch die Zwischenschicht erfolgt.

5. Verfahren nach einem der vorhergehenden Ansprüche, **dadurch gekennzeichnet, dass** das die Zwischenschicht (CI) bildende Material in Bezug auf Silicium selektiv geätzt wird und dass die Zwischenschicht nach der Implantation von Störstellen entfernt wird.

6. Verfahren nach Anspruch 5, **dadurch gekennzeichnet, dass** Bereiche (PK) durch schräge Implantation von Störstellen des Typs, der zu jenem entgegengesetzt ist, der für die Implantationen der Source, des Drains und der Source- und Drain-Erweiterungsbereiche (LDD) verwendet wird, gebildet werden und dass diese schräge Implantation nach dem Entfernen der Zwischenschicht ausgeführt wird.

7. Verfahren nach Anspruch 3, **dadurch gekennzeichnet, dass** auf den Seitenflächen des Gates (GR) und auf einem Teil des Substrats ein Abschnitt (CIR) der Zwischenschicht nach der Implantation zurückgelassen wird und dass isolierende seitliche Bereiche, die sich an den Seitenflächen des Gates und an einem Teil des Substrats abstützen, verwirklicht werden, wobei diese isolierenden seitlichen Bereiche (ESP) den restlichen Abschnitt der Zwischenschicht, auf dem ein anderes Material aufgebracht ist, enthalten.

8. Verfahren nach einem der vorhergehenden Ansprüche, **dadurch gekennzeichnet, dass** die Implantationsenergie in der Weise gewählt wird, dass eine maximale Verteilung der Störstellen in einer Tiefe von wenigstens 3 bis 4 Nanometern erhalten wird.

9. Verfahren nach einem der vorhergehenden Ansprüche, **dadurch gekennzeichnet, dass** die Abmessung des Gates, gerechnet parallel zur Länge des Kanals, kleiner ist als 180 Nanometer, beispielsweise kleiner als 100 Nanometer.
